# EUROPEAN PATENT APPLICATION

(11) **EP 2 068 406 A1**
(43) Date of publication of application: **10.06.2009**
(21) Application number: 08160511.5
(22) Date of filing: 16.07.2008
(51) Int. Cl.: H01S 5/026, H01S 5/0687, H01S 5/14, H01S 3/13, H01S 3/137, H01S 3/139, H01S 3/067

(54) **Tunable laser light source and controlling method of the same**

(30) Priority: 04.12.2007 JP 2007313243
(71) Applicant: Tecdia Co., Ltd., Tokyo 170-6020 (JP)
(72) Inventor: Koyama, Etsuo, Toshima-ku Tokyo Tokyo 170-6020 (JP); Nagai, Yasuo, Toshima-ku Tokyo Tokyo 170-6020 (JP)
(74) Representative: Brötz, Helmut

(57) **Abstract**

The objective of the present invention is to provide with a tunable laser light source and controlling method of the same capable of detecting the degree of out-of-tune-ness, maintaining simple configuration. The tunable laser light source comprises a gain medium 1, a tunable band rejector 2, an etalon 3, and a transmitted light detector 4. The gain medium 1 is capable of amplifying light within a wavelength band including a target wavelength. The a tunable band rejector 2 is positioned opposite the gain medium thereby forming an edge of a laser resonator and is capable of rejecting light with a certain wavelength tunable to the target wavelength from the incident light emanating from the gain medium while transmitting the remaining. The an etalon 3 is positioned between the gain medium and the tunable band rejector and is capable of selectively transmitting light with certain wavelengths including the target wavelength. The a transmitted light detector 4 is positioned to the place where its incident light enters through the tunable band rejector and is capable of detecting the power of the light. The tunable laser light source 100 may further comprise an optical coupler 5, a beam splitter 6, and a branched off light detector 7. Here, the optical coupler 5 is capable of coupling with the laser beam emanating from the gain medium 1. The beam splitter 6 branches off a part of this laser beam. The branched off light detector 7 consists of such as a photodiode and is capable of detecting the beam branched off by the beam splitter 6.

## Description

### BACKGROUND OF THE INVENTION

### Technical Field

The present invention relates to a tunable laser light source and controlling method of the same, the tunable laser light source comprising an external resonator and capable of selectively tuning a wavelength.

### Description of Related Art

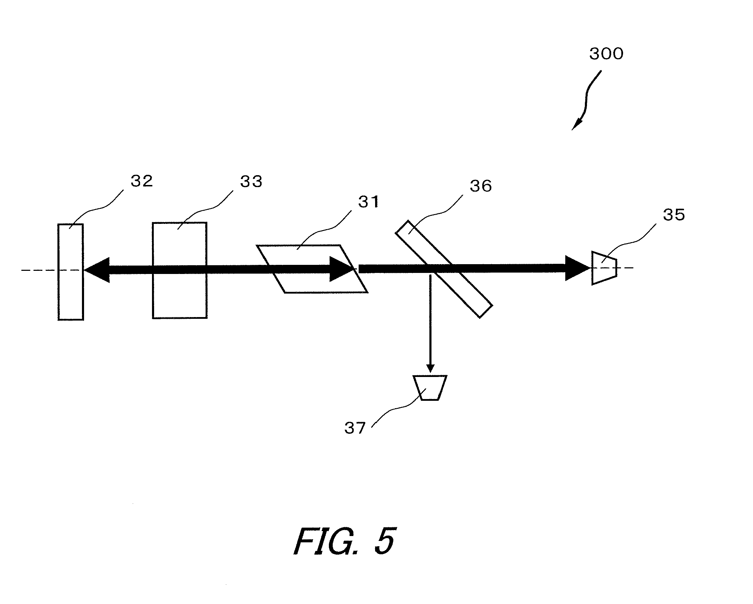

Hitherto, a tunable laser light source of external resonator type is known, the tunable laser light source comprising a gain medium, a mirror, and a wavelength selector and capable of selectively tuning a lasing wavelength (refer, for example, to Patent Document 1.). FIG. 5 is a view for schematically explaining the principle of the operation of the tunable laser light source of external resonator type of the prior art. The tunable laser light source 300 usually comprises, as shown in FIG. 5, a gain medium 31 consisting of a semiconductor device, a band reflection mirror 32 for reflecting the light with a certain wavelength, and an etalon 33. Here, the etalon 33 is positioned between the gain medium 31 and the band reflection mirror 32 and is capable of selectively transmitting the light with certain wavelengths. The light emanating from the gain medium 31 to an optical coupler 35 is partially branched off by a beam splitter 36; and the branched off light is directed to an optical detector 37, for such as monitoring use.

Since having a stable high Q-factor, the etalon 33 is generally used to define the lasing wavelength and stabilize it. The overlapping wavelength between the reflection wavelength of the band reflection mirror 32 and the transmission wavelengths of the etalon 33 is selected as the lasing wavelength; and then the light with the lasing wavelength is directed to the optical coupler 35. Hitherto the tuning, i.e., overlapping this way is performed based on a priori known optical property of the band reflection mirror 32.
[Patent Document 1] US20050035295

However, the tunable laser light source and controlling method of the same of the prior art have a problem that it is not easily to detect a "degree of out-of-tune-ness" representing a deviation from the target tuning point. Therefore, hitherto, it is general to use lots of parts and/or particular devices for controlling or apply a complex controlling method.

### SUMMARY OF THE INVENTION

Considering the aforementioned state of art, the objective of the present invention is to provide with a tunable laser light source and controlling method of the same capable of detecting the degree of out-of-tune-ness, maintaining simple configuration.

The present invention provides following configurations in order to achieve the aforementioned objective.
(1) The invention of claim 1 provides with a tunable laser light source, comprising: a gain medium capable of amplifying light within a wavelength band including a target wavelength; a tunable band rejector positioned opposite said gain medium thereby forming an edge of a laser resonator and capable of rejecting light with a certain wavelength tunable to the target wavelength from the incident light emanating from said gain medium while transmitting the remaining; an etalon positioned between said gain medium and said tunable band rejector and capable of selectively transmitting light with certain wavelengths including the target wavelength; and a transmitted light detector positioned to the place where its incident light enters through said tunable band rejector and capable of detecting the power of the light.

(2) The invention of claim 2 provides with a method for controlling the tunable laser light source of claim 1, the method comprising the steps of: detecting output of said transmitted light detector; and adjusting a target wavelength of the tunable band rejector so as that the output of said transmitted light detector directs to that of the in-tune state.

According to the invention of claim 1, it is possible to provide with a tunable laser light source capable of detecting degree of out-of-tune-ness maintaining simple configuration. This is supported by the fact that the tunable laser light source of claim 1 comprises the gain medium, the tunable band rejector, the etalon, and the transmitted light detector that configured as follows. Here, the gain medium is capable of amplifying light within a wavelength band including a target wavelength. The tunable band rejector is positioned opposite the gain medium thereby forming an edge of a laser resonator and is capable of rejecting light with a certain wavelength tunable to the target wavelength from the incident light emanating from the gain medium while transmitting the remaining. The etalon is positioned between the gain medium and the tunable band rejector and is capable of selectively transmitting light with certain wavelengths including the target wavelength. The transmitted light detector is positioned to the place where its incident light enters through the tunable band rejector and is capable of detecting the power of the light.

According to the invention of claim 2, it is possible to provide with a method for controlling the tunable laser light source capable of detecting degree of out-of-tune-ness maintaining simple configuration. This is supported by the fact that the method comprises the steps of: detecting output of said transmitted light detector; and adjusting a target wavelength of the tunable band rejector so as that the output of said transmitted light detector directs to that of the in-tune state.

### BRIEF DESCRIPTION OF THE DRAWINGS

FIG. 1 is a block diagram schematically illustrating an exemplary tunable laser light source according to the present invention.
FIG. 2 is a view for explaining the power of the light entering the transmitted light detector: (a) out-of-tune state, and (b) in-tune state.
FIG. 3 is a view schematically illustrating the out-of-tune characteristic of the transmitted light detector in response to the incident light.
FIG. 4 is a view schematically illustrating an example of the configuration for stabilizing the light emanating from the gain medium to the optical coupler.
FIG. 5 is a view for schematically explaining the principle of the operation of the tunable laser light source of external resonator type of the prior art.

### DETAILED DESCRIPTION OF THE PREFERRED EMBODIMENTS

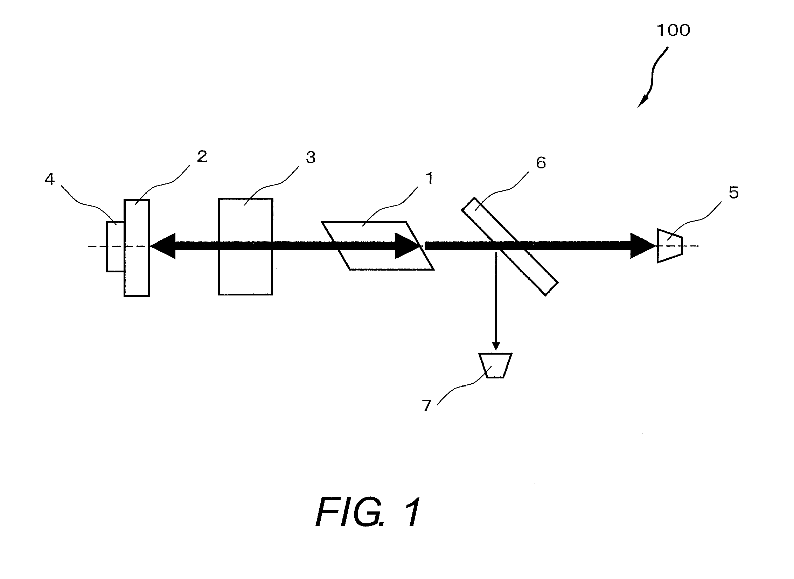

Hereinafter, referring to the accompanying drawings illustrating exemplary configurations, descriptions are made on embodiments according to the present invention. FIG. 1 is a block diagram schematically illustrating an exemplary tunable laser light source according to the present invention. The tunable laser light source 100 is usable as a light source, for example, for the optical communication and comprises a gain medium 1, a tunable band rejector 2, an etalon 3, and a transmitted light detector 4. Here, the gain medium 1 is capable of amplifying light within a certain wavelength range including a target wavelength; the tunable band rejector 2 is positioned to the place opposite the gain medium 1; the etalon 3 is aligned between the gain medium 1 and the tunable band rejector 2. The transmitted light detector 4 is positioned to the place where its incident light enters through the tunable band rejector 2.

The gain medium 1 consists of, for example, a semiconductor amplifier, a so-called fiber amplifier, and so on and is capable of amplifying light with a wavelength within the communication band. The etalon 3 has a transmission spectrum, in which certain selected wavelengths including the aforementioned target wavelength are capable of transmitting.

The tunable band rejector 2 selectively rejects the light with a certain target wavelength in a tunable manner from the incident light entering from the gain medium 1 while transmits the remaining component. The tunable band rejector 2 may consist of, for example, a liquid crystal device capable of changing the target wavelength by adjusting its applied voltage. Further specifically, "Tunable wavelength liquid crystal filter" obtainable from TECDIA co. ltd. is available as the tunable band rejector 2.

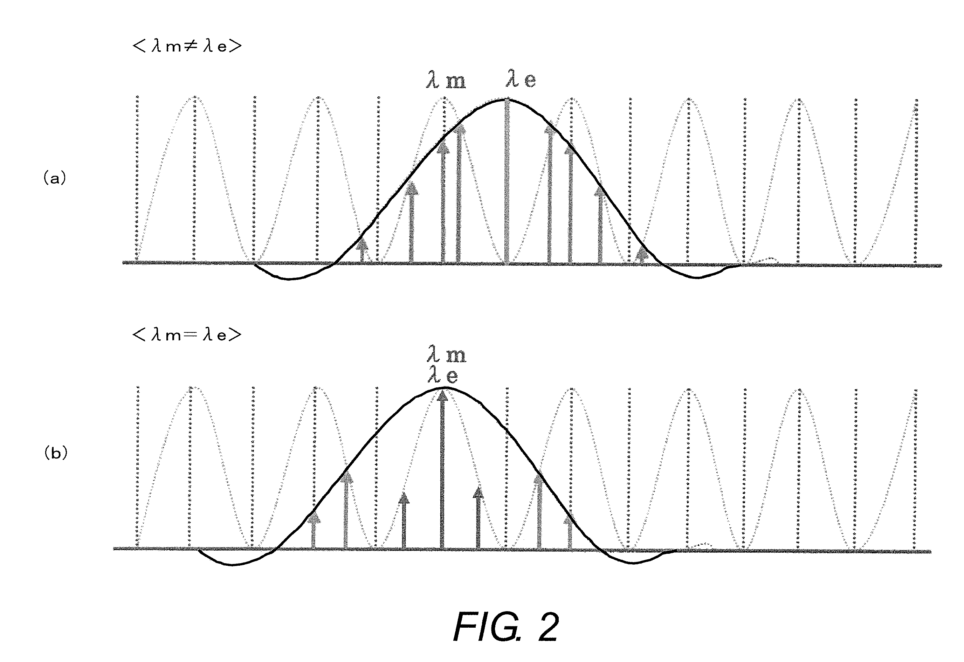

The transmitted light detector 4 consists of, such as, a photodiode and is capable of detecting the power of the light transmitting through the tunable band rejector 2. FIG. 2 is a view for explaining the power of the light entering the transmitted light detector: (a) out-of-tune state, and (b) in-tune state. Here, "tune" means to overlap the peak of the rejection spectrum of the tunable band rejector 2 and one of peaks of transmission spectrum of the etalon 3. In FIG. 2, the rejection spectrum of the tunable band rejector 2 is illustrated by a solid line; the transmission spectrum of the etalon 3 is illustrated by a broken line. The power of the light entering the transmitted light detector 4 changes between the out-of-tune state (a) and the in-tune state (b) by the amount (hereinafter, referred to as "rejected power component.") defined by integrating the product of the rejection spectrum and the transmission spectrum with respect to the wavelength.

In the out-of-tune state, the rejected power component is determined, as can be seen in FIG. 2(a), mainly based on a central peak (its apex is marked with ".Iamda.e.") of the rejection spectrum and its neighboring two peaks (one of their apices is marked with the target wavelength ".Iamda.m.") of the transmission spectrum. To the contrary, in the in-tune state, the rejected power component is similarly defined, as can be seen in FIG. 2(b), based on the central peak of the rejection spectrum and its neighboring three peaks (marked with arrows) of the transmission spectrum.

Thus, the power of the light entering the transmitted light detector 4 has a difference between the out-of-tune state (a) and the in-tune state (b). The output of the transmitted light detector 4 includes this difference in a detectable manner, therefore the difference of the rejected power component from the in-tune state (b). The tunable laser light source may optionally comprise a band pass filter positioned on the optical path between the tunable band rejector 2 and the transmitted light detector 4. Here, the band path filter is capable of eliminating components not substantially contributing to the change in the rejected power component. For example, such a band pass filter can be selected from those eliminating wavelengths beyond a certain wavelength range around the central peak of the rejection spectrum. Thereby, it is possible to improve the detection sensitivity of the change in the rejected power component.

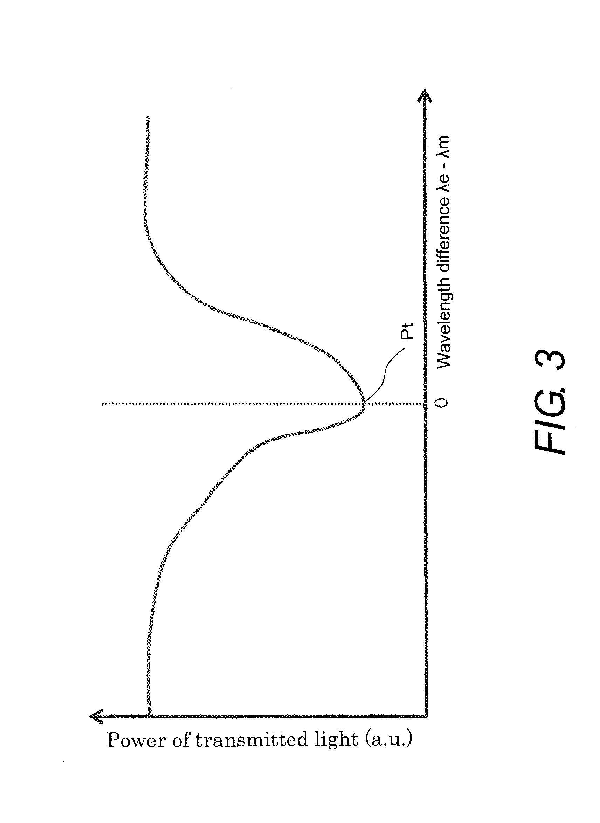

FIG. 3 is a view schematically illustrating the out-of-tune characteristic of the transmitted light detector in response to the incident light. In FIG. 3, the degree of out-of-tune-ness, i.e., the difference between the aforementioned .lamda.e and the .lamda.m is shown along the abscissa; and the detected power of the light is shown along the ordinate. In the example shown in FIG. 3, a minimum occurs at the in-tune point P in the power of the light entering the transmitted light detector 4. However, the power of the light entering the transmitted light detector 4 doesn't necessarily have a minimum at the in-tune point Pt and may have an extremum or another particular value in accordance with the adopted configuration of the tunable laser light source.

In addition, the tunable laser light source 100 may further comprise, as shown in FIG. 1, an optical coupler 5, a beam splitter 6, and a branched off light detector 7. Here, the optical coupler 5 is capable of coupling with the laser beam emanating from the gain medium 1. The beam splitter 6 branches off a part of this laser beam. The branched off light detector 7 consists of, such as, a photodiode and is capable of detecting the beam branched off by the beam splitter 6.

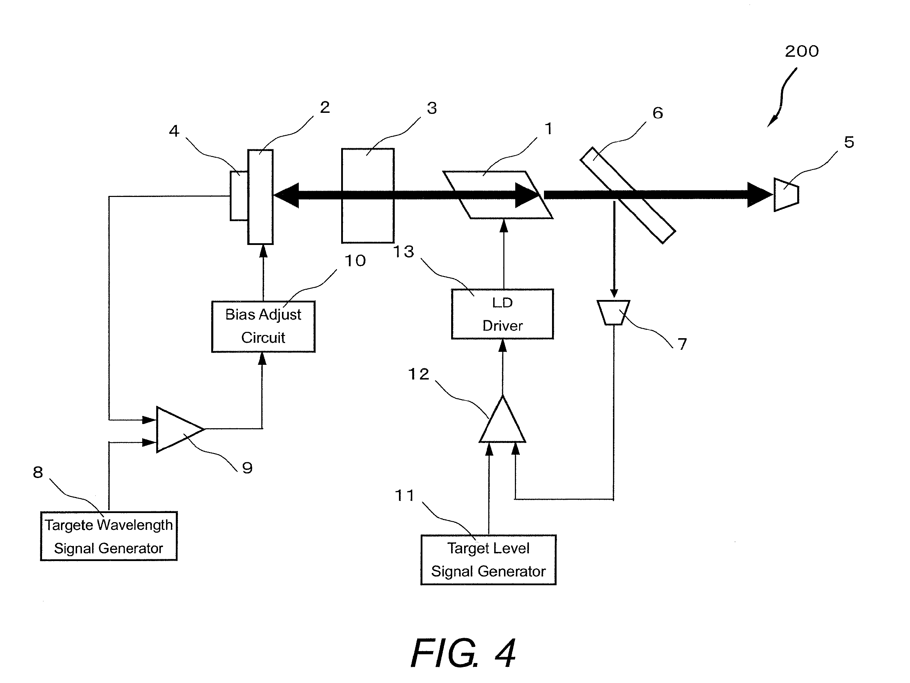

FIG. 4 is a view schematically illustrating an example of the configuration for stabilizing the light emanating from the gain medium to the optical coupler. In FIG. 4, the same symbol refers the same mean composing the tunable laser light source 100; and its detail description will be omitted.

The tunable laser light source 200 comprises a tuning control unit having a target wavelength signal generator 8, a wavelength controller 9, and a bias adjust circuit 10. Here, the target wavelength signal generator 8 is capable of generating target wavelength signal representing the target wavelength of the tunable band rejector 2. The wavelength controller 9 receives the output of the transmitted light detector 4 and the target wavelength signal and is capable of generating wavelength control signal depending on the degree of out-of-tune-ness being determined based on these signals. The bias adjust circuit 10 is capable of adjusting the target wavelength of the tunable band rejector 2 depending on the wavelength control signal output from the wavelength controller 9. Further, the target wavelength signal generator 8 generates a signal representing the output of the transmitted light detector 4 in the in-tune state, for example, it generates voltage signal corresponding to the extremum (minimum) illustrated in the FIG. 3. The wavelength controller 9 generates, for example, signal corresponding to the degree of out-of-tune, as an analogue DC voltage. The bias adjust circuit 10 may be configured by such as a DC/AC converter and thereby generates AC voltage to be output to the tunable band rejector 2 consisting of such as a liquid crystal device.

The tunable laser light source 200 further comprises an LD level control unit having the aforementioned branched off light detector 7, a target level signal generator 11, a level controller 12, and an LD driver 13. Here, the aforementioned branched off light detector 7 is capable of generating branched off light level signal representing the power of the incident light branched off from the beam splitter 6. The target level signal generator 11 is capable of generating target level signal representing the target level of the light emanating from the gain medium 1 to such as the optical coupler 5. The level controller 12 is capable of generating level control signal depending on the level deviation from the target level; the level deviation is determined based on both the branched off light level signal and the target level signal that are input thereto. The LD driver 13 is capable of driving the gain medium 1 depending on the level control signal. Further, the aforementioned level control signal is generated to control the level deviation from the target level within a certain range and consists of, for example, analogue voltage signal.

The tunable laser light source and controlling method of the same according to the present invention is usable as an optical source for the optical communication and so on, particularly for the WDM (Wavelength Divisional Multiplexing) communication.

## Claims

1. A tunable laser light source, comprising:
a gain medium capable of amplifying light within a wavelength band including a target wavelength;
a tunable band rejector positioned opposite said gain medium thereby forming an edge of a laser resonator and capable of rejecting light with a certain wavelength tunable to the target wavelength from the incident light emanating from said gain medium while transmitting the remaining;
an etalon positioned between said gain medium and said tunable band rejector and capable of selectively transmitting light with certain wavelengths including the target wavelength; and
a transmitted light detector positioned to the place where its incident light enters through said tunable band rejector and capable of detecting the power of the light.

2. A method for controlling the tunable laser light source of claim 1, the method comprising the steps of: detecting output of said transmitted light detector; and adjusting a target wavelength of the tunable band rejector so as that the output of said transmitted light detector directs to that of the in-tune state.
